Europäisches Patentamt

**European Patent Office**

Office européen des brevets

(19)

(11) Publication number: **0 185 837**

**A1**

(12)

# EUROPEAN PATENT APPLICATION

(21) Application number: **85107804.8**

(22) Date of filing: **25.06.85**

(51) Int. Cl.⁴: **H 01 L 29/78**

(30) Priority: **16.11.84 US 672379**

(43) Date of publication of application:
**02.07.86 Bulletin 86/27**

(84) Designated Contracting States:
**DE FR GB NL**

(71) Applicant: **EATON CORPORATION**
**Eaton Center 111 Superior Ave.**
**Cleveland Ohio 44114(US)**

(72) Inventor: **Benjamin, James Anthony**
**20865 Hawthorne Ridge Court**
**Waukesha Wisconsin 53186(US)**

(72) Inventor: **Lade, Robert Walter**
**1009 North Jackson Street Apartment 2302**
**Milwaukee Wisconsin 53202(US)**

(72) Inventor: **Schutten, Herman Peter**
**8545 North Fielding Road**
**Bayside Wisconsin 53217(US)**

(72) Inventor: **Jaskolski, Stanley Vincent**
**N76 W22144 Chestnut Hill Road**
**Sussex Wisconsin 53089(US)**

(74) Representative: **Wagner, Karl H.**
**WAGNER & GEYER Patentanwälte**
**Gewuerzmuehlstrasse 5 Postfach 246**
**D-8000 München 22(DE)**

(54) **Efet, bidirectional lateral power fet.**

(57) Lateral FET structure is disclosed for bidirectional power switching, including AC application. A basic building block configuration is provided by a pair of channel regions (134, 136) laterally spaced along a substrate (104) affording a drain or drift region (140) therebetween, and by a pair of source regions (114, 116) each forming a junction with a respective channel region. Upon application of voltage of either polarity across main terminals (T1, T2) connected to the source regions, current flow in either direction between the source regions is controlled by the potential on a gate electrode (138) proximate the channels. A multi-cell matrix array is also disclosed.

Fig. 12

EP 0 185 837 A1

-1-

## EFET, BIDIRECTIONAL LATERAL POWER FET

### Technical Field

The invention relates to power switching
semiconductors, and more particularly to power MOSFETs
(metal oxide semiconductor field effect transistors),
and the like.

## Background

The present invention evolved from efforts to develop a solid state device for high power switching applications to replace the low current circuit breaker or contactor, though the invention is of course not limited thereto. Performance requirements for such a device are demanding, and even modest specifications might include a 400 volt blocking capability with a corresponding ON state resistance of 0.05 ohms and an AC current rating of 20 amps rms. Further, the system should be capable of interrupting a fault current of 5,000 amps without destroying itself. Additionally, manufacturing cost should be less than or equal to the circuit breaker or contactor cost.

High power switching in solid state devices has evolved over the last 30 years from the early milliwatt devices to the present kilowatt "hockey puck" thyristor devices. Device processing has evolved from the early restrictive alloy/rate grown devices to planar and MOS VLSI structures, bringing the blocking voltages of switches from the 10 volt level of the 1950's to the kilovolt range today. Even with these great strides, however, the problem of developing a semiconductor device to replace the low current circuit breaker or contactor has remained unsolved.

There are three likely candidates for high power switching applications. Two of these are bipolar, i.e. they depend on the flow of two types of carriers, majority and minority. The third is unipolar, i.e. it depends only on majority carrier current flow.

The first two candidates are the thyristor and the bipolar transistor. Although the thyristor is capable of blocking a high reverse voltage, it can be characterized in the forward ON state by a fixed voltage source (one junction drop) and a resistance with a negative temperature coefficient, i.e. resistance decreases with increasing temperature. The bipolar transistor can be characterized in the forward ON state simply as a resistance with a negative temperature coefficient. In each case, it is extremely difficult to accommodate large current ratings through the paralleling of bipolar devices due to the effect of "current hogging". If a number of these devices are paralleled, and if one unit draws slightly more current than the others, it will heat up and its resistance will be reduced. This results in a still larger share of the current, further heating, etc. The result is usually the thermal destruction of that device and the subsequent overloading of the others. In general, current hogging prevents paralleling of these devices unless ballast resistance, a form of stabilizing negative feedback, is introduced. This resistance further adds to the total ON state resistance and is therefore highly undesirable. Other disadvantages are false dv/dt triggering of thyristors, and secondary breakdown problems in bipolar transistors.

The third candidate, the field effect transistor (FET), is exclusively a majority carrier device. Its resistance is related to temperature through the electron mobility. Its resistance has a positive temperature coefficient, namely the resistance

0185837

is proportional to $T^{3/2}$. Since the electron mobility is 2.5 times greater than the hole mobility in silicon, the n channel device leads to lower ON state resistance. Further, since MOS devices give conductivity enhancement in the ON state, these devices are generally more conductive than their junction depletion-mode counterparts (JFET). Additionally, since minimal channel length (for low ON state resistance) and high packing densities are desirable, the vertical power MOSFET presently is leading all others in the power switching field.

Current commercially available MOSFETs have performance specifications approximately one order of magnitude below the minimal requirements noted above. Two current designs are the SIPMOS device and the HEXFET device, discussed more fully hereinafter.

Summary

The present invention provides lateral power FET structure which is bidirectional, i.e. current can flow in either direction when the device is in the ON state, whereby to afford AC application.

The device is called an EFET and provides a basic building block structure for various lateral bidirectional devices.

Right and left laterally spaced source regions and channel regions have a drift region current path therebetween. Gate electrode means controls bidirectional conduction.

The structure of the invention enables substantial reduction in chip size as compared with the area required for two unidirectional FETS connected in series opposition.

· In a desirable aspect, the structure is suited to manufacture in a repetitive multi-cell matrix array, affording plural FET integrated structure.

## Brief Description of the Drawings
### Prior Art

Figs. 1 through 11 show prior art.

Fig. 1 is a schematic cross-sectional view of a VMOS FET.

Fig. 2 is a schematic cross-sectional view of a DMOS FET.

Fig. 3 is a schematic cross-sectional view of a VMOS FET with a polysilicon gate.

Fig. 4 is a schematic cross-sectional view of a DMOS FET with a polysilicon gate (HEXFET).

Fig. 5 shows a top view of the structure of Fig. 4, illustrating the HEX outline.

Fig. 6 is a schematic cross-sectional view of a SIPMOS FET.

Figs. 7 - 10 schematically illustrate the process steps yielding the structure of Fig. 6.

Fig. 11 is a schematic cross-sectional view of a lateral MOSFET.

### Present Invention

Figs. 12 through 15 illustrate the present invention.

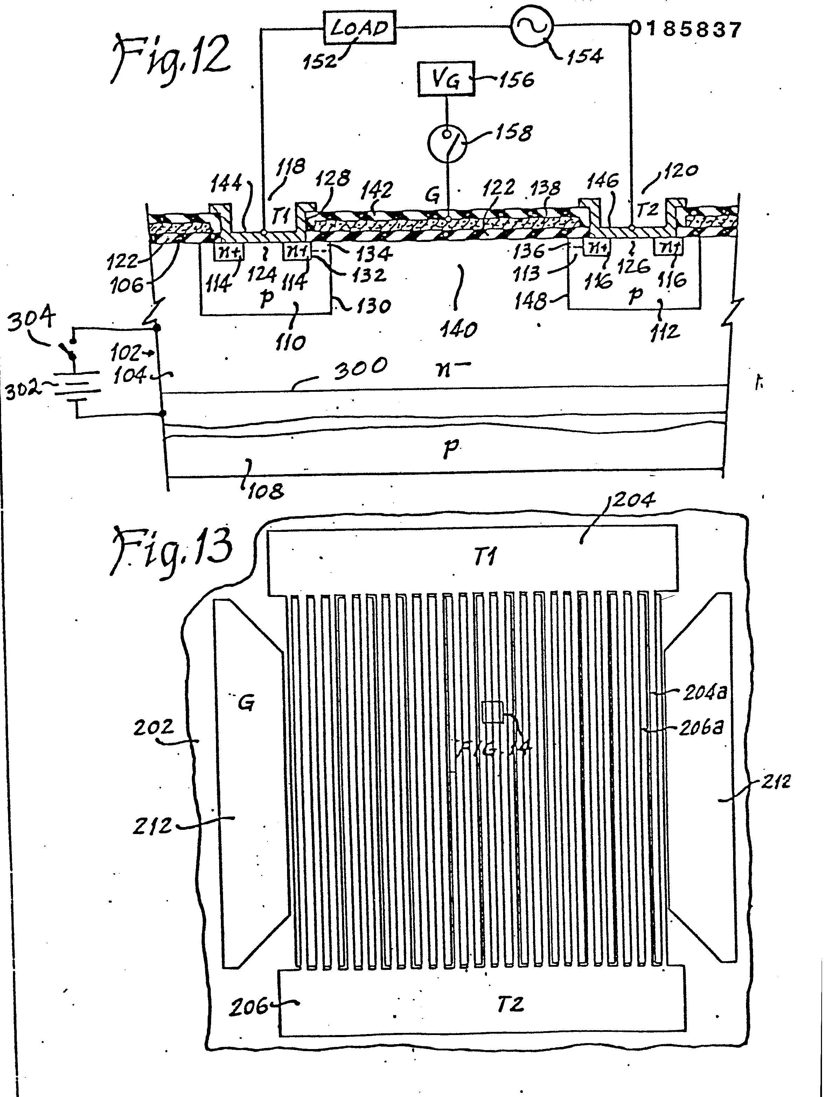

Fig. 12 is a schematic cross-sectiontal view of bidirectional lateral power FET structure constructed in accordance with the invention, called EFET.

Fig. 13 is a schematic top view of a semiconductor chip having a plurality of bidirectional FETs integrated thereon in a matrix array.

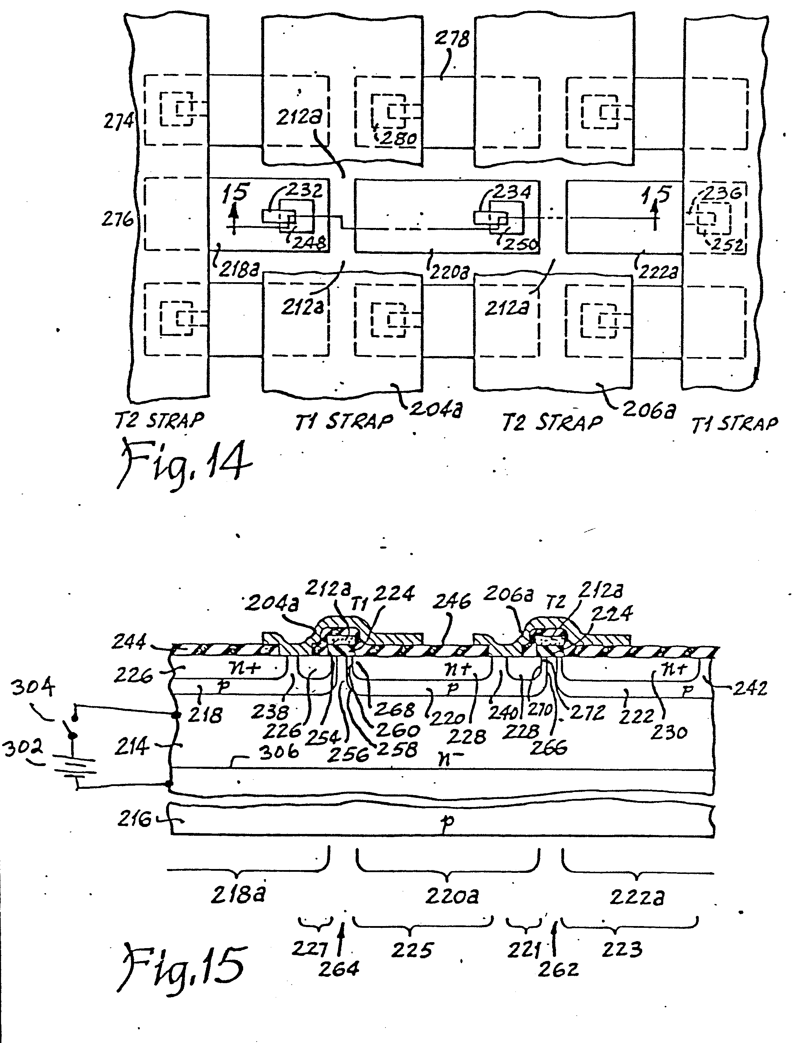

Fig. 14 is an enlarged view of the correspondingly outlined section of Fig. 13.

Fig. 15 is a cross-sectional view taken along line 15-15 in Fig. 14.

Description of Prior Art and Power MOSFET Technology

MOSFETs can generally be classified into two groupings according to the principle orientation of current flow, namely vertical and lateral. For the vertical units, there are two predominant geometries: planar (HEXFET, TMOS, SIPMOS, etc.); and non-planar (VMOS, UMOS, etc.). The advantage that these devices enjoy over their lateral counterparts is that the drain contact is placed on the bottom of the chip. Thus, for a given chip area, higher current ratings (higher packing densities) are possible. As a consequence, almost all power MOSFET design has been concentrated on vertical configurations.

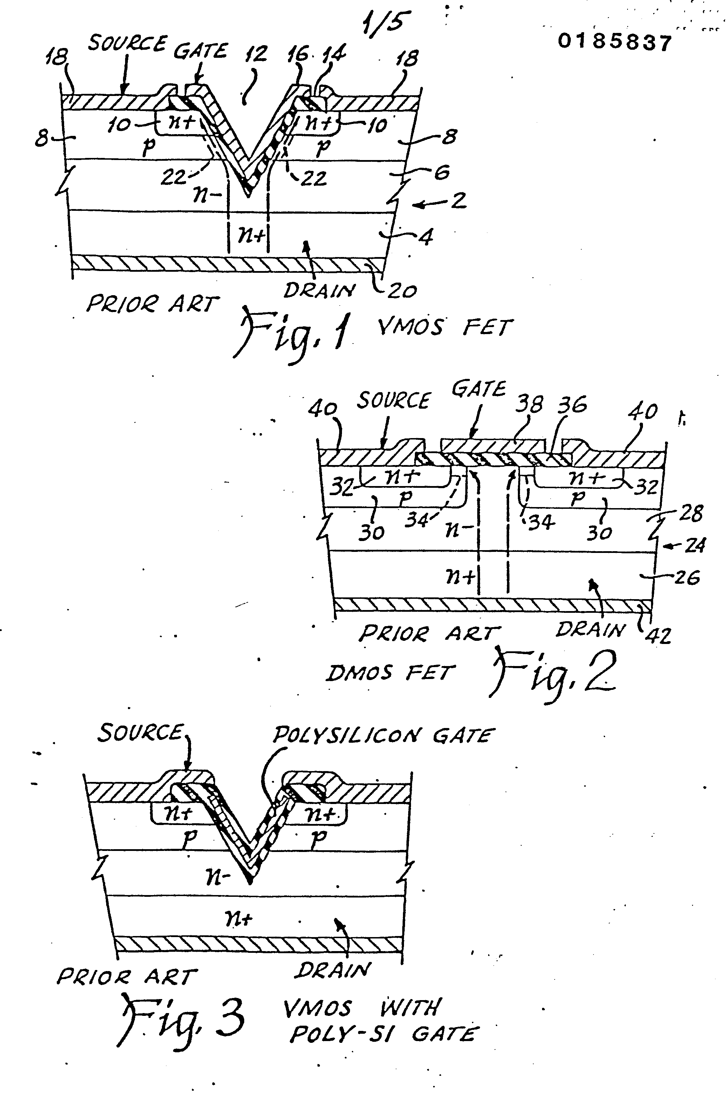

A cross-sectional view of a typical non-planar vertical device is illustrated in Fig. 1, showing a VMOS structure 2. The starting material is an n+ silicon wafer 4 with an n- epitaxial layer 6. Successive p and n+ diffusions are carried out, yielding layers 8 and 10. A groove is anisotropically etched to yield V-groove 12. An insulating oxide layer 14 is formed in the groove, followed by deposition of gate metalization 16. Source metalization 18 is deposited on the top major surface, and drain electrode metalization 20 is deposited on the bottom major surface.

FET channel 22 is through p region 8 along the edge of the V-groove. Upon application of a positive voltage on gate electrode 16 relative to source electrode 18, electrons in p region 8 are attracted into channel 22 to invert the conductivity type of the channel to n type. Electrons may then flow from source region 10 through channel 22 to drain region 4, and hence current may flow from drain electrode 20 through drain region 4 through channel 22 through source region 10 to source electrode 18.

0185837

One of the main advantages of the VMOS design is that the active channel length is extremely small and is determined by the difference in depth between the n+ source diffusion 10 and the p body diffusion 8. The technology in diffusion is sufficiently well advanced so that this dimension can be very tightly controlled. Thus the channel resistance can be closely held to a maximum specification.

One type of VMOS or UMOS (truncated VMOS) design is the notched MOSFET structure, for example "A Parametric Study of Power MOSFETs", C. Hu, IEEE Electron Device Conference, paper CH1461-3/79, 0000-0385. Notched groves as narrow as 1 micron are provided by anisotropic etching, IEEE Transactions Electron Device, Volume ED-25, #10, October 1978, and "UMOS Transistors on (110) Silicon", Ammar and Rogers, Transactions IEEE, ED-27, May 1980, pages 907-914

An alternative configuration is the DMOS (double diffused metal oxide semiconductor) FET 24, Figure 2. N+ starting material 26 has an n- epilayer 28 into which p and n+ diffusions form regions 30 and 32. FET channel region 34 is formed at the top major surface over which insulating layer 36 is deposited, followed by gate metalization 38. Upon application of a positive voltage on gate electrode 38 relative to source electrode 40, electrons in p type region 30 are attracted towards the gate and congregate at the top major surface to thus invert the conductivity type along channel region 34 to n type. Current thus flows from drain electrode 42 through regions 26 and 28 and then through channel region 34 and then through source region 32 to source electrode 40, as shown by dashed line.

In the VMOS, UMOS and DMOS devices, the p body and the n+ source diffusions are carried out through the same opening in a silicon dioxide covering layer. As a consequence, the active channel region in DMOS FETs is also controlled by the difference in the diffusion depths.  Lateral penetration is about 80% that of the vertical depth.

Stability of the operating specifications in MOS devices involves control of their threshold voltages, i.e. the value of the gate voltage required to produce the onset of drain to source conduction.  This parameter is strongly influenced by the surface conditions of the silicon just over the channel region and the purity of the silicon dioxide, $SiO_2$, such as layers 14, Fig. 1, and 36, Fig. 2.  During the thermal growth of the oxide, hydrogen chloride is introduced into the system to act as a gettering agent, thus providing fairly pure material.

A particularly troublesome element is sodium because any $Na+$ ions in the oxide tend to reduce the threshold of n channel devices, and an overabundance of them can prevent turn-off altogether.  If aluminum gate metal is placed directly onto the gate oxide, these ions, if present in the aluminum, can drift into the silicon dioxide and degrade the device performance. This is true for VMOS, UMOS, and DMOS devices.

If, however, the transistors are fabricated with a phosphorous rich polycrystalline silicon (polysilicon or poly-si) gate, the technology for these materials allows much purer gates to be constructed with much more stable thresholds.  Examples of VMOS and DMOS (HEXFET) devices utilizing this technology are shown in Figs. 3 and 4.  Fig. 5 shows a top view of the structure of Fig. 4, illustrating the HEX outline.  Gate electrode connections are attached along the edge of the wafer. The VMOS structure is classified as a vertical non-planar unit.  The HEXFET structure is a vertical planar unit.

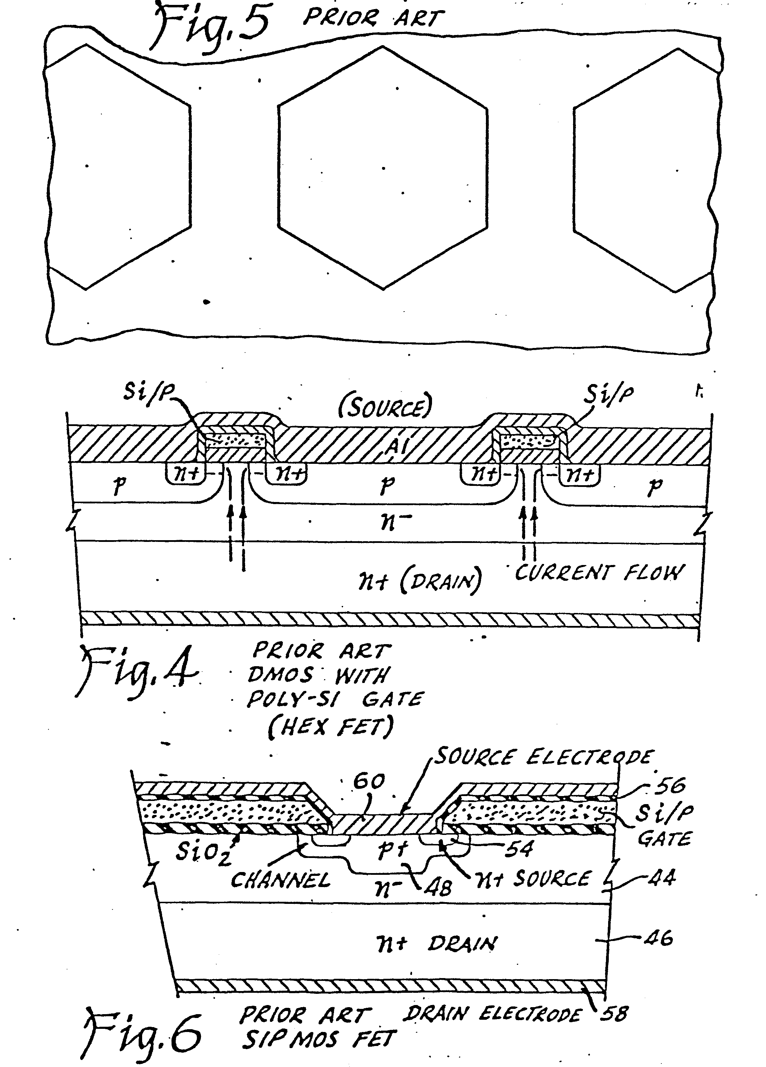

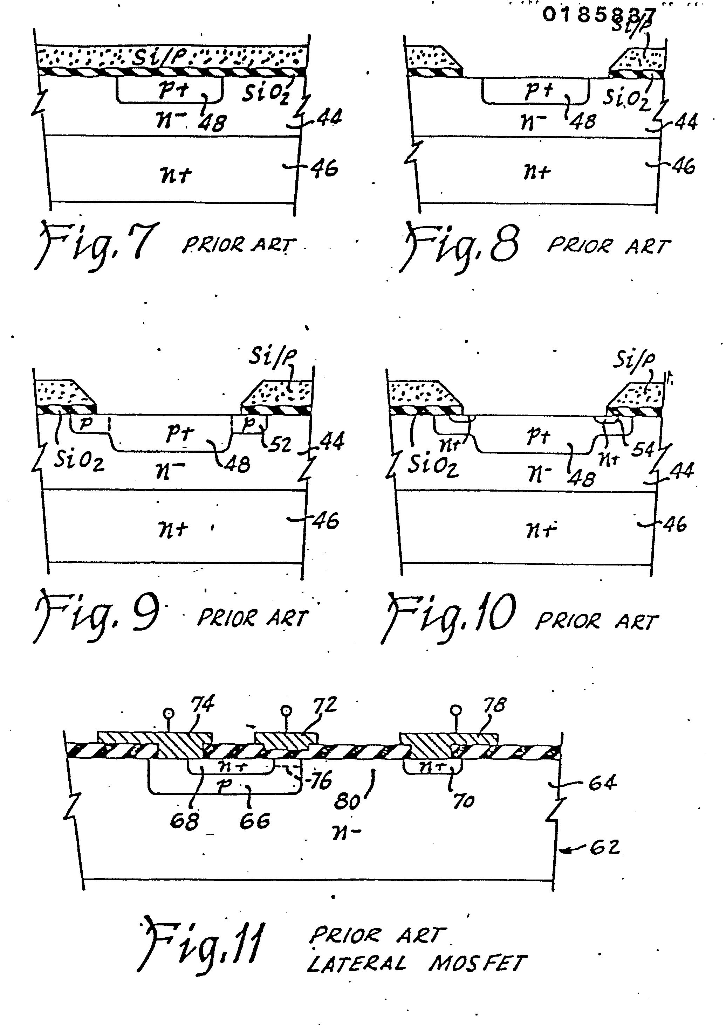

Another vertical planar unit is the SIPMOS structure shown in Fig. 6. An n- epitaxial layer 44 is grown on an n+ substrate 46, Fig. 7. The thickness and resistivity of epilayer 44 is determined by the breakover voltage versus ON state resistance compromise. Using standard photolithography techniques, a p+ layer 48 (boron) is driven into the epilayer approximately 2 to 3 microns. The wafer is then stripped of old silicon dioxide and a new extremely clean 50 to 60 nanometer silicon dioxide layer is grown, usually in an environment of hydrogen chloride. Polycrystalline silicon is then deposited on top of the wafer using the LPCVD (low pressure chemical vapor deposition) method. An n+ diffusion into the entire polysilicon layer is then performed to provide for the gettering action of the phosphorous against sodium ions and provide a means to reduce the resistivity· of the gate material, although it will still be a factor of 3,000 higher than aluminum. The entire surface of the polysilicon-phosphorous (Si/P) layer is bombarded by ion implantation in order to intentionally damage the top surface. Photoresist material is placed on the Si/P, developed and etched. Since the top etches faster than the bottom, due to the damage, the taper shown in Fig. 8 results. By using this tapered gate arrangement, the subsequent implants are more uniform up to the silicon gate oxide surface.

A light, carefully controlled, ion implanted p region 52, Fig. 9, is now added, which will be the channel region. After implantation, a drive-in diffusion moves this layer about one micron below the wafer surface. No oxide masking is needed because the Si/P gate serves that function as mentioned above. An n+ source region 54 is now ion implanted through the same opening in the Si/P gate grid structure. The impurity density is selected such that p+ region 48 is greater than n+ source region 54, and the depth of n+ source region 54 is typically 0.4 microns. A heavy low temperature oxide layer 56, Fig. 6, is applied, followed by a pre-ohmic and ohmic aluminum step yielding drain electrode 58 and source electrode 60.

As noted above, almost all power MOSFET design has been concentrated on vertical configurations. An example of the other general class of MOSFETs, the lateral type, is shown in Fig. 11.

Lateral MOSFET 62 has a substrate including an n- epitaxial layer 64 into which are diffused p region 66, n+ source region 68 and n+ drain region 70. Upon application of a positive voltage on gate electrode 72 relative to source electrode 74, electrons in p region 66 are attracted to the top surface of the substrate to invert the conductivity type along channel region 76 to n type, whereby electrons flow from source 68 through channel 76 through drift region 80 to drain 70, and current thus flows from drain electrode 78 through channel 76 to source electrode 74. The principal advantage of lateral device 62 is ease of implementation in integrated geometries where all leads are accessible.

As with the previously mentioned vertical MOSFETs, the lateral MOSFET 62 of Fig. 11 is unidirectional.

It will be noted that each of the above references is to enhancement mode devices. Since the electron mobility is about 2.5 times greater than the hole mobility in silicon, the most common channel is n type. The ON state channel resistance is determined by the degree to which one can enhance the initial conductivity of the semiconductor. Thus larger gate voltages generally produce lower ON state resistances. If the devices were constructed as depletion mode units, the ON state resistance occurring at zero gate signal

0185837

would be fixed by the conductivity of the starting material. Little if any reduction in ON state resistance could be effected by application of gate voltage. Since the starting resistivity must be high in order to sustain high blocking voltages in the OFF state, the ON state resistance of depletion mode devices currently being fabricated is considered too large to be a serious contender in power FET development. From this perspective, since all current JFETs are depletion mode devices, JFET configurations have not been seriously considered for power switching applications.

Detailed Description of the Invention

Reviewing Figs. 1 through 11, it is seen that in each case the transistor will not support a reverse drain to source voltage. Each device is unidirectional in that only one junction drop separates drain and source when (for the n channel devices shown) the drain is negative with respect to the source. In many applications, these devices can be effectively employed. But if AC line voltage is to be the drain-source driving function, then a bidirectional design becomes mandatory. Again; inspection of the device geometries in Figs. 1 through 11 shows that the reason for the unidirectional design stems from the use of the device as a three terminal element, i.e. both the drain and the gate voltages are referenced to the common source point. It is necessary that the source electrode be in contact with the n+ source region and also with the p body region (to provide the gate return contact). Thus, the blocking action of the pn epijunction is negated.

Referring to Fig. 1, for example, if device 2 were supplied with a separate electrode for p region 8, and the source metalization 18 contacted only the n+ source region 10, a bidirectional FET would result. There would be considerable asymmetry due to unequal blocking capabilities of the n region 6 and p region 8. Likewise in Fig. 11, if a separate electrode is provided for p region 66 and if source metalization 74 contacted only source region 68, then a bidirectional FET would result, but there would be considerable asymmetry due to the unequal blocking capabilities of n region 64 and p region 66. Thus a new geometry and perhaps technology would be required.

The present invention evolved from efforts to provide bidirectionality in a power FET without having to overcome these immediately above noted difficulties.

The present invention provides a simple yet effective power MOSFET structure avoiding these difficulties yet providing bidirectional current flow.

Fig. 12 schematically shows the bidirectional FET structure constructed in accordance with the invention. FET 102 includes a substrate 104 of semiconductor material of one conductivity type having a top major surface 106. In preferred form, substrate 104 is an n-epitaxial layer grown on a base layer of semiconductor material such as p layer 108. A silicon dioxide insulating layer 122 is grown on top major surface 106, followed by deposition of polysilicon gate electrode 138, followed by a top silicon dioxide insulating layer 142.

A pair of p tub regions 110 and 112 are diffused into substrate 104 through holes 118 and 120 in the silicon dioxide and polysilicon layers on top major surface 106. N+ regions 114 and 116 are diffused into respective p regions 110 and 112 through the same holes 118 and 120, respectively, comparably to the double diffusion process noted above. N+ region 114 is prevented from forming in the central section 124 of p region 110 by a separate masking step, or in accordance with the SIPMOS process noted above, and likewise for central section 126 of p tub 112. Both the p and the n+ diffusions are performed through the same hole, and thus the oxide edge 128 provides aligned registry. The diffusion parameters control the lateral penetration of p edge 130 and n+ edge 132, which in turn control the lateral length of channel region 134 formed therebetween, and likewise for channel region 136.

Gate electrode 138, insulatingly spaced above major surface 106, extends across both channel regions 134 and 136 and across a central section 140 of substrate 104 which extends upwardly between the channel regions to the top major surface. Metalizations 144 and 146 are deposited in openings 118 and 120 to ohmically contact respective source regions 114 and 116 and respective tub regions 110 and 112. Metalizations 146 and 148 provide the main electrodes for current flow through the device as controlled by gate electrode 138.

Upon application of a positive voltage to gate terminal 138 with respect to source region 114 and main terminal 144, electrons in p region 110 are attracted to top major surface 106 to thus invert the conductivity type in channel region 134 to n type. If main terminal 146 is positive with respect to main terminal 144, current may then flow from p region 112 momentarily across forward biased pn junction 148 into drift region 140, then through channel 134 to source 114 and terminal 144. Since gate 138 extends along and above drift region 140, majority carriers, electrons, are attracted to top major surface 106 to thus provide conductivity enhancement. As soon as current starts to flow through the FET, the voltage across the main terminals drops, which in turn reduces the potential in the various regions of the FET, including portion 113 of p tub 112 below the other FET channel 136. Portion 113 thus becomes negative relative to gate 138, whereby positive gate 138 attracts electrons toward top major surface 106 to thus invert the conductivity of channel 136 to n type and hence render channel 136 conductive. Forward biased pn junction 148 thus conducts only momentarily until the second channel 136 turns on. The main current path through FET 102 is from main terminal 146, through source 116, through channel 136, through drift region or drain 140, through channel 134, through source 114 to main terminal 144.

The structure is bilateral, and thus current may also flow from main terminal 144 to main terminal 146 when gate 138 is positive with respect to source 116. Electrons in p region 112 are attracted to top major surface 106 by gate terminal 138 thereabove to thus invert channel region 136 to n type, and hence allow electron flow from n+ source 116 through channel allow electron flow from n+ source 116 through channel 136 into drift region 140. If terminal 144 is positive with respect to terminal 146, current then flows from p region 110 momentarily across forward biased pn junction 130 until channel 134 turns on. The main current path is thus from main terminal 144, through source 114, through channel 134, through drift region 140, through channel 136, through source 116 to main terminal 146.

In the absence of gate potential on gate terminal 138, channel regions 134 and 136 are p type, and the device is in a blocking OFF state. Current from main terminal 144 to main terminal 146 is blocked by junction 148. Current flow in the other direction from main terminal 146 to terminal 144 is blocked by junction 130. Drift region 140 in substrate 104 acts as a common drain for each side of the FET and withstands high voltage due to its large area, described more fully hereinafter.

It is thus seen that bidirectional FET 102 includes a first source region 114 of one conductivity type semiconductor material, a first channel region 134 of opposite conductivity type semiconductor material forming a junction 132 with first source region 114, a drift region 140 of the one conductivity type semiconductor material forming another junction 130 with first channel region 134, a second channel region 136 of the opposite conductivity type forming a junction 148 with drift region 140, and a second source region 116 of the one conductivity type forming a junction with the second channel region 136.

Gate electrode means 138 are disposed proximate the first and second channel regions 134 and 136 and adapted for application of an electrical potential for producing electric fields of sufficient intensity to invert the conductivity type in at least a portion of the first and second channel regions 134 and 136. Upon application of voltage of either polarity to the first and second source regions 114 and 116, electric current can flow in a respective corresponding direction between them, under control of the electrical potential of the gate electrode means 138.

Channel regions 134 and 136 are laterally spaced by drift region 140 extending upwardly between the channel regions to top major surface 106 of the FET. Source regions 114 and 116 are laterally spaced along top major surface 106, and the channel regions 134 and 136 and the drift region 140 are disposed between the source regions 114 and 116.

Gate electrode means 138 includes in preferred form a continuous gate electrode terminal extending laterally along top major surface 106 and spaced thereabove by a layer of insulation 122. Gate electrode 138 extends across first channel region 134, then across drift region 140, then across the second channel region 136.

Main electrode means 144 and 146 each conductively communicate with a respective one of the embedded n type source regions 114 and 116 for serving as an electron current source when a negative voltage is applied to one of the main electrode means relative to the voltage on the other, and serving as an anode when a positive voltage is applied to one of the main electrodes relative to the voltage on the other main electrode. Gate electrode 138, upon application of electrical potential, produces controllable electric fields in channel regions 134 and 136 such that current flow in either direction between spaced apart source regions 114 and 116 is controllable by controlling the potential on the gate electrode 138.

Bidirectional FET 102 may be used to control AC power. Fig. 12 schematically shows a load 152 and a source of AC power 154 connected across main terminals 144 and 146 of the FET. Gate terminal 138 is connected to a source of gate potential 156 through switch means 158. In the ON state of FET 102, switch 158 is closed such that a given polarity potential is applied to gate terminal 138.

When main terminal 146 is positive with respect to main terminal 144, as driven by AC source 154, gate terminal 138 is positive with respect to source region 114 and terminal 144 connected to p region 110. Hence, channel 134 is inverted to n type and conduction occurs, i.e. current flows from positive main terminal 146 through source region 116, through channel 136, through drift region 140, through channel 134 through source 114 to negative terminal 144 and through load 152.

In the other half cycle of the AC source 154, main terminal 144 is positive with respect to main terminal 146, whereby gate terminal 138 is positive with respect to source region 116 and p region 112 connected to negative terminal 146. Conduction is thus enabled through channel 136, and current flows from positive terminal 144 through source 114, through channel 134, through drift region 140, through channel 136, to source 116 and terminal 146.

In preferred form, gate 138 is allowed to float in the OFF state of device 102. This enables a higher blocking voltage in the OFF state than if gate 138 were tied to the same potential reference level as one of the sources 114 or 116 when switch 158 is off.

Other gating arrangements and techniques are, of course, feasible, as is well recognized in the art. For example, the gate may be driven from the AC line power from source 154 through appropriate threshold and

0185837

protective circuitry, or may be driven through synchronizing circuitry such as a phase-lock loop from the AC line to be clocked at a given point in each cycle, or may be driven from an optically or otherwise isolated gate power source. One desirable type of gating arrangement is that shown in U.S. Patent Number 4,477,742, issued October 16, 1984, wherein a current source is connected to a common point between the FET gates, which common gate point is referenced through a resistor and a pair of diodes to the most negative of the main electrodes. The load and AC source may also be connected in a variety of manners as well known in the art, for example the AC source may be coupled to the FET through an isolation transformer.

Figs. 13 through 15 show the preferred implementation of the schematic structure of Fig. 12. Fig. 13 is a top view of a semiconductor chip 202 having a plurality of bidirectional FETs integrated thereon in a matrix pattern or array. The main terminals 204 (T1) and 206 (T2), corresponding to terminals 144 and 146 of Fig. 12, extend in interdigitated fashion by means of long narrow parallel terminal straps 204a and 206a to interconnect the plurality of FETs. Gate terminal 212 is extended to each side and interconnects the various gates, 138 in Fig. 12, by means of a continuous waffle-like pattern 212a, Fig. 14.

Fig. 14 is an enlarged view of the corresponding outlined section of Fig. 13. Fig. 15 is a cross-sectional view taken as shown in Fig. 14. A substrate 214, Fig. 15, is provided by an n- epitaxial layer grown on a p type base layer 216. A plurality of p diffusions form p tub regions 218, 220, 222, and so on as defined by a waffle-like oxide pattern 224. The boundaries of these p tubs define a plurality of cells in the substrate such as shown in Fig. 14 at 218a, 220a, 222a, and so on. These cells are arranged in a plurality of rows and columns. The plurality of bidirectional FETs formed by the cells are connected in parallel between main terminals 204 and 206.

An n+ diffusion is carried out in the cells formed by the p tub regions to yield n+ source regions 226, 228, 230, and so on. The areas in Fig. 14 designated 232, 234, 236, and so on, are masked or otherwise processed (for example in accordance with the above noted SIPMOS process) to prevent n+ diffusion thereunder and/or a p+ diffusion is then carried out thereunder to yield p+ regions 238, 240, 242, and so on, Fig. 15, which are continuously crystalline with the corresponding p tub sections and extend upwardly to top major surface 244.

Polysilicon gate 212a, deposited on oxide 224, is covered by insulating silicon dioxide layer 246 extending as shown in Fig. 15. Apertures 248, 250, 252, and so on, through which the diffusions are performed, also receive deposited main terminal strap metalizations to yield main terminal 204a ohmically contacting source region 226 and p tub region 218, and main terminal 206a ohmically contacting n+ source region 228 and p tub region 220.

Upon application of a positive voltage at gate terminal 212a with respect to source region 226, electrons in p tub region 218 are attracted to the top major surface 244 beneath gate terminal 212a and invert the conductivity type along channel region 254 to n type such that electrons may flow from source 226 through channel 254 into drain or drift region 256 which is a section of substrate 214 extending upwardly to top major surface 244 between p tubs 218 and 220. If main terminal 206a is positive with respect to main terminal 204a then current can flow from p region 220 momentarily across forward biased pn junction 258 into drift region 256 and through channel region 254 to source 226 and terminal 204a. As before, as soon as current starts to flow through the FET, the voltage across the main terminals drops, which in turn reduces the potential in the various regions of the FET, including the portion 261 of p tub 220 below channel 260. Portion 261 thus becomes negative relative to gate 212a whereby positive gate 212a attracts electrons toward top major surface 244 to thus invert the conductivity of channel 260 to n type and hence render channel 260 conductive. Forward biased pn junction 258 thus conducts only momentarily until the second channel 260 turns on. The main current path through the FET is then from main terminal 206a, through source 228, through channel 260, through drain or drift region 256, through channel 254, through source 226 to main terminal 204a. Current flows in the reverse direction along the same path when main terminal 204a is positive with respect to main terminal 206a.

Each of the cells 218a, 220a, 222a, and so on, in the matrix array has a right portion forming a lateral FET in combination with a left portion of the next adjacent cell to the right in the same row. Correspondingly, each cell has a left portion forming a lateral FET in combination with the right portion of the next adjacent cell to the left in the same row. For example, cell 220a has a right portion 221, Fig. 15, forming a lateral FET 262 with a left portion 223 of cell 222a. Also, cell 220a has a left portion 225 forming a lateral FET 264 with a right portion 227 of cell 218a. Each of the FETs 262 and 264 is bidirectional.

As seen in Fig. 15, each cell, e.g. cell 220a has a p tub region in substrate 214 extending laterally and then upwardly to top major surface 244 to form right and left boundaries defining right and left junctions, e.g. 258 and 266, with substrate 214. Source region 228 has right and left portions extending laterally and then upwardly to top major surface 244 to define right and left junctions 268 and 270 with the right and left upward extensions of tub region 220. The right and left upward extensions of tub region 220 form right and left FET channels 260 and 272 immediately below top major surface 244. The right and left portions of source region 228 also extend laterally towards each other and then upwardly to top major surface 244 such that intermediate portion 240 of tub region 220 extends upwardly to top major surface 244 between the right and the left portions of source region 228. As seen in Fig. 14, the channel regions are part of respective tub regions extending laterally at least partially around respective source regions.

Main terminal 206a ohmically interconnects upwardly extending intermediate tub region portion 240 with the intermediate tub region portion of alternate cells. The other main terminal 204a ohmically interconnects upwardly extending intermediate tub region portion 238 with the remaining staggered set of alternate cells, as seen in Fig. 14. Gate terminal 212a is insulated above top major surface 244 by oxide 224 in a waffle-like or matrix pattern. Each respective gate terminal portion 212a overlies and extends across the right FET channel, such as 254, of a left cell, then across the upwardly extending drift portion, such as 256, of the substrate 214 between the cells, then across the left FET channel, such as 260, of a right cell.

The upwardly extending portions of the substrate such as 256 beneath the gate terminal array likewise form a waffle-like pattern separating the rows and columns of the cells in the matrix array. The intermediate tub region portions, such as 240, are offset to the right or the left of center in their respective cells such that the main terminal connection point is likewise offset to the right or left in each cell.

In a first row of cells, for example row 274, Fig. 14, each cell has a main terminal connection point to the left of center to thus have a left-hand orientation. In a second row of cells, for example row 276, each cell has a main terminal connection point to the right of center to thus have a right-hand orientation. The main terminals 204a and 206a extend in column form perpendicular to the rows, Fig. 14. As above noted and as seen in Fig. 13, the main terminal straps extend parallel to each other in interdigitated manner. Each strap is wide enough to straddle portions of adjacent cells as shown in Fig. 14 by T1 strap 204a straddling cells 218a and 220a. Each strap is insulated above the gate terminal by silicon dioxide layer 246, Fig. 15. As seen in Fig. 14, main terminal strap 204a ohmically contacts left-hand oriented cell 278 therebeneath at area 280 in first row 274, and then ohmically contacts right-hand oriented cell 218a at area 248 therebeneath in second row 276, and so on.

Sublayer 108, Fig. 12, forms a junction 300 with drift region 140. Substrate 104, including drift region 140, is formed of semiconductor material lightly doped toward intrinsic n type, nu. Means are provided for reverse biasing junction 300 to substantially fully deplete drift region 140 and substantially remove all mobile carriers therefrom and prevent unwanted conductivity inversion therealong beneath the top major surface under gate 138 during the OFF state. This affords increased OFF state voltage blocking capability. The intrinsic nu type material of drift region 140 enables a very small reverse bias potential across junction 300 to fully deplete drift region 140 up to top major surface 106. In the embodiment in Fig. 12, the biasing depletion means includes voltage source 302 and switch 304. In the OFF state, switch 304 is closed. Source 302 reverse biases junction 300. Because substrate 104 is lightly doped to intrinsic nu type, drift region 140 is substantially fully depleted and substantially all mobile carriers are removed therefrom between channels 134 and 136. Single drift region 140 thus not only supports OFF state blocking voltage in both directions, but also affords increased OFF state voltage blocking capability because of the prevention of unwanted conductivity inversion therealong due to the absence of carriers.

In Fig. 15, substrate 214 is doped to intrinsic nu type, and the junction 306 between p sublayer 216 and substrate 214 is reverse biased in the OFF state by source 302. This enables the plurality of singular drift regions such as 256 to each support OFF state blocking voltage in both directions, and also affords increased OFF state voltage blocking capability. Since singular drift region 256 supports OFF state blocking voltage in both directions, there is a substantial reduction in total drift region depletion path length otherwise required for two back-to-back drift regions each supporting blocking voltage respectively in one direction only. The present invention thus increases chip utilization efficiency and provides more FETs per unit lateral area by a factor of 3 to 4. This substantially increases lateral packing density and in turn provides more FETs and even higher power capability per unit lateral area.

It is recognized that various modifications are possible within the scope of the appended claims.

CLAIMS

1. A bidirectional FET, comprising:

a first source region of one conductivity type semiconductor material;

a first channel region of opposite conductivity type semiconductor material forming a junction with said first source region;

a single drift region of semiconductor material lightly doped toward instrinsic said one conductivity type and forming a junction with said first channel region;

a second channel region of said opposite conductivity type semiconductor material forming a junction with said drift region;

a second source region of said one conductivity type semiconductor material forming a junction with said second channel region; and

gate electrode means disposed proximate said first and second channel regions and adapted for application of an electrical potential for producing electric fields of sufficient intensity to invert the conductivity type in at least a portion of said first and second channel regions;

whereby upon application of voltage of either polarity to said first and second source regions, electric current can flow in a respective corresponding direction between them, under control of said electrical potential of said gate electrode means;

said single drift region supporting OFF state blocking voltage in both directions to substantially reduce total drift region depletion path length otherwise required for two back-to-back drift regions each supporting blocking voltage respectively in one direction only;

a sublayer of said opposite conductivity type semiconductor material forming a junction with said drift region; and

means for reverse biasing said last mentioned junction to substantially fully deplete said intrinsic single drift region between said channel regions and substantially remove all mobile carriers therefrom and prevent unwanted conductivity inversion therealong during the OFF state and afford increased OFF state voltage blocking capability.

2. The invention according to claim 1 wherein said channel regions are laterally spaced by said drift region extending upwardly between said channel regions to a top major surface of said FET.

3. The invention according to claim 2 wherein said source regions are laterally spaced along said top major surface, and wherein said channel regions and said drift region are disposed between said source regions.

4. The invention according to claim 3 wherein said channel regions are part of respective tub regions of said opposite conductivity type extending laterally at least partially around respective said source regions, and comprising a pair of main electrodes each connected to a respective said source region and its respective said tub region to ohmically short each respective said source and channel region.

5. The invention according to claim 4 wherein said gate electrode means comprises a continuous gate electrode extending laterally along said top major surface and spaced thereabove by a layer of insulation, said gate electrode extending across said first channel region, then across said drift region, then across said second channel region.

6. A bidirectional laterally integrated power switching plural FET structure, comprising:

a substrate of semiconductor material of one conductivity type having a top major surface;

a first tub region of the other conductivity type in said substrate along said top major surface;

first and second source region portions of said one conductivity type in said first tub region laterally spaced along said top major surface;

. a second tub region of said other conductivity type in said substrate laterally spaced from said first tub region along said top major surface;

third and fourth source region portions of said one conductivity type in said second tub region laterally spaced along said top major surface;

a first singular drift region of semiconductor material lightly doped toward intrinsic said one conductivity type and formed by said substrate between said first and second tub regions and forming a junction with said first tub region and forming a junction with said second tub region, said first singular drift region supporting OFF state blocking voltage in both directions to substantially reduce total drift region depletion path length otherwise required for two back-to-back drift regions each supporting blocking voltage respectively in one direction only, whereby to afford substantially increased lateral packing density and in turn more FETs and even higher power capability per unit lateral area;

third, fourth and so on, tub regions in said substrate, having fifth and sixth, seventh and eighth, and so on, source region portions, and second and so on singular drift regions therebetween;

a first gate electrode insulatingly spaced above said top major surface and extending across the section of said first tub region between said second source region portion and said substrate, then across the section of said substrate between said first and second tub regions, and then across the section of said second tub region between said substrate and said third source region portion;

a second gate electrode insulatingly spaced above said top major surface and extending across the section of said second tub region between said fourth source region portion and said substrate, then across the section of said substrate between said second and third tub regions, and then across the section of said third tub region between said substrate and said fifth source region portion;

third, fourth, and so on, gate electrodes;

a first main electrode ohmically connected to said first and second source region portions and the section of said first tub region therebetween;

a second main electrode ohmically connected to said third and fourth source region portions and the section of said second tub region therebetween;

third, fourth, and so on, main electrodes;

said section of said first tub region between said second source region portion and said substrate comprising a first channel region along said top major surface, and said section of said second tub region between said substrate and said third source region portion comprising a second channel region along said top major surface, such that given gate potential on said first gate electrode attracts given polarity carriers to invert said first and second channel regions to said one conductivity type such that current may flow in either direction between said first and second main electrodes;

said section of said second tub region between said fourth source region portion and said substrate comprising a third channel region, and said section of said third tub region between said substrate and said fifth source region portion comprising a fourth channel region, such that said given gate potential on said second gate electrode attracts said given polarity carriers and inverts said third and fourth channel regions to said one conductivity type such that current may flow in either direction between said second and third main electrodes, and so on.

7. The invention according to claim 6 comprising:

gate terminal means ohmically interconnecting each of said gate electrodes;

first main terminal means ohmically interconnecting said first, third, fifth, and so on main electrodes; and

second main terminal means ohmically interconnecting said second, fourth, and so on main electrodes.

8. The invention acccording to claim 7 wherein:

said first and second main terminal means are connectable across an AC load line;

said gate terminal means is connectable to a source of gate potential;

such that said gate terminal means is positive with respect to one of said main terminal means during the first half cycle of said AC line, and is positive with respect to the other of said main terminal means during the second half cycle of said AC line;

such that during the first half cycle of said AC line, current flows from said other main terminal means through the odd numbered of said source regions, through the even numbered of said channel regions, through said sections of said substrate extending upwardly between said tub regions, through the odd numbered of said channel regions, through the even numbered of said source regions to said one main terminal means; and

such that during the second half cycle of said AC line, current flows from said one main terminal means through the even numbered of said source regions, through the odd numbered of said channel regions, through said sections of said substrate extending upwardly between said tub regions, through the even numbered of said channel regions, through the odd numbered of said source regions to said other main terminal means.

9. An integrated plural lateral FET structure for bidirectional power switchings comprising:

a semiconductor chip comprising a substrate of one conductivity type;

a plurality of laterally spaced cells forming a matrix array on said substrate along a top major surface thereof;

each said cell having a right-hand portion forming a lateral FET in combination with left-hand portion of the next adjacent cell to the right;

each said cell having a left-hand portion forming a lateral FET in combination with the right-hand portion of the next adjacent cell to the left;

a plurality of singular drift regions of semiconductor material lightly doped toward intrinsic said one conductivity type and formed by said substrate between respective said cells, each said singular drift region supporting OFF state blocking voltage in both directions to substantially reduce total drift region depletion path length otherwise required for two back-to-back drift regions each supporting blocking voltage respective in one direction only, whereby to increase chip utilization efficiency and provide more FETs per unit lateral area by a factor of 3 to 4;

each cell comprising:

a tub region of opposite conductivity type in said substrate and extending laterally and then upwardly to said top major surface to form right and left boundaries defining right and left junctions with said substrate;

source region means of said one conductivity type in said tub region and having right and left portions extending laterally and then upwardly to said top major surface to define right and left junctions with said right and left upward extensions of said tub region;

said right and left upward extensions of said tub region forming right and left FET channels immediately below said top major surface;

said right and left source region portions also extending laterally towards each other and then upwardly to said top major surface such that an intermediate portion of said tub region extends upwardly to said top major surface between said right and left source region portions;

first main terminal means ohmically interconnecting said upwardly extending intermediate tub region portion at said top major surface with the intermediate tub region portion of alternate cells;

second main terminal means ohmically interconnecting said upwardly extending intermediate tub region portions of the remaining alternate cells;

gate terminal means insulated above said top major surface of said substrate in a waffle-like pattern, with each respective gate terminal portion overlying and extending across said right FET channel of a left cell, then across said upwardly extending portion of said substrate between said cells, then across said left FET channel of a right cell, said upwardly extending portion of said substrate beneath said gate terminal means likewise forming a waffle-like pattern separating the rows and columns of said cells in said matrix array.

10. The invention according to claim 9 wherein said upwardly extending intermediate tub region portion is offset to the right or left of center in said cells such that said main terminal connection point is likewise offset to the right or left in each cell;

in a first row of cells, each cell having said main terminal connection point to the left of center to thus have a left-hand orientation;

in a second row of cells, each cell having said main terminal connection point to the right of center to thus have a right-hand orientation.

11. The invention according to claim 10 wherein said first and second main terminal means extend in column form perpendicular to said rows, said first and second main terminal means extending parallel to each other in interdigitated manner by means of a plurality of terminal straps, each strap extending perpendicularly across said rows and being wide enough to straddle portions of adjacent cells in each row, each strap insulated above said gate terminal means, a given strap ohmically contacting a left-hand oriented cell therebeneath in a first row and then ohmically contacting a right-hand oriented cell therebeneath in the second row, and so on.

12. The invention according to claim 11 wherein said gate terminal means attracts given polarity carriers to invert said channel regions to said one conductivity type in response to given gate potential, such that current may flow in either direction between said first and second main terminal means.

13. The invention according to claim 12 wherein:

said main terminal means are connectable across an AC load line;

said gate terminal means is connectable to a source of gate potential;

such that said gate terminal means is positive with respect to said first main terminal means during the first half cycle of said AC line, and is positive with respect to said second said terminal means during the second half cycle of said. AC line;

such that during the first half cycle of said AC line, current flows from said second main termial means through the left source region portions of right cells, through the left FET channels of right cells, through said upwardly extending portions of said substrate between said cells, through the right FET channels of left cells, through the right source region portions of left cells to said first main terminal means; and

such that during the second half cycle of said AC line, current flows from said first main terminal means through the right source region portions of left cells, through the right FET channel of left cells, through the upwardly extending portions of said substrate between cells, through the left FET channels of right cells, through the left source region portions of right cells to said second main terminal means.

PRIOR ART

Fig. 1 VMOS FET

PRIOR ART

DMOS FET   Fig. 2

PRIOR ART

Fig. 3   VMOS WITH POLY-SI GATE

0185837

### Fig. 5 PRIOR ART

*Fig. 5 PRIOR ART*

Si/P (SOURCE) Si/P

Al

$n+$ | $n+$ | $n+$ | $n+$

$p$ | $p$ | $p$

$n-$

$n+$ (DRAIN) | CURRENT FLOW

### Fig. 4 PRIOR ART DMOS WITH POLY-SI GATE (HEX FET)

SOURCE ELECTRODE

60 | 56 | Si/P GATE

$SiO_2$ | 54

CHANNEL | $p+$ | $n+$ SOURCE | 44

$n-$ | 48

$n+$ DRAIN | 46

DRAIN ELECTRODE 58

### Fig. 6 PRIOR ART SIP MOS FET

0185837

**Fig. 7** PRIOR ART

**Fig. 8** PRIOR ART

**Fig. 9** PRIOR ART

**Fig. 10** PRIOR ART

**Fig. 11** PRIOR ART
LATERAL MOSFET

# Fig.12

# Fig.13

Fig. 14

T2 STRAP   T1 STRAP   T2 STRAP   T1 STRAP

Fig. 15

## EUROPEAN SEARCH REPORT

European Patent
Office

EP 85 10 7804

### DOCUMENTS CONSIDERED TO BE RELEVANT

| Category | Citation of document with indication, where appropriate, of relevant passages | Relevant to claim | CLASSIFICATION OF THE APPLICATION (Int Cl.4) |
|---|---|---|---|
| Y | US-A-4 199 774 (THE BOARD OF TRUSTEES OF THE LELAND STANFORD JUNIOR UNIVERSITY) <br> * Figures 2,7; page 5, line 48 – page 6, line 21 * | 1 | H 01 L 29/78 |
| A | | 2-5 | |
| Y | SOLID-STATE ELECTRONICS, vol. 19, no. 4, April 1976, pages 297-306, Pergamon Press Ltd., Oxford, GB; B. FARZAN et al.: "Depletion V-groove MOS (VMOS) power transistors" <br> * Figure 1; paragraph 2 * | 1 | |
| A | EP-A-0 099 175 (EATON CORP.) <br> * Figures 12-16; abstract * | 1-4,6-13 | TECHNICAL FIELDS SEARCHED (Int. Cl.4) <br><br> H 01 L |
| A | COMPUTER DESIGN, March 1974, pages 44,46, Computer Design Publishing Corp., Concord, US; "A double-diffused MNOS transistor as a new nonvolatile memory" <br> * Figure (a) * | 1-5 | |

The present search report has been drawn up for all claims

| Place of search | Date of completion of the search | Examiner |
|---|---|---|
| THE HAGUE | 11-03-1986 | GELEBART J.F.M. |